# EUROPEAN PATENT APPLICATION

(11) **EP 4 131 430 A1**
(43) Date of publication of application: **08.02.2023**
(21) Application number: 21781024.1
(22) Date of filing: 08.02.2021
(51) Int. Cl.: H01L 31/107, H01L 21/3205, H01L 21/768, H01L 23/522, H01L 27/144, H01L 27/146

(54) **LIGHT RECEIVING ELEMENT AND ELECTRONIC DEVICE**

(30) Priority: 31.03.2020 JP 2020065335
(71) Applicant: Sony Semiconductor Solutions Corporation, Atsugi-shi Kanagawa 243-0014 (JP)
(72) Inventor: MAEDA, Hidenori, Kikuchi-gun, Kumamoto 869-1102 (JP); ISHIBASHI, Kenzo, Kikuchi-gun, Kumamoto 869-1102 (JP)
(74) Representative: Müller Hoffmann & Partner
(86) International application number: PCT/JP2021/004523
(87) International publication number: WO 2021/199681

(57) **Abstract**

Crosstalk is reduced.

Alight receiving element includes pixels, a wiring region, and a separation region. The pixels have photoelectric conversion units, each photoelectric conversion unit being disposed in a semiconductor substrate to perform photoelectric conversion of incident light. The wiring region has a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate. The separation region is disposed in the semiconductor substrate at a boundary between the pixels, is formed in a shape which penetrates the semiconductor substrate and in which a width on the front surface side is wider than a width on the back surface side, and separates the photoelectric conversion units from each other.

## Description

### [Technical Field]

The present disclosure relates to a light receiving element and electronic equipment. More specifically, the present disclosure relates to a light receiving element that detects light from an object and electronic equipment that uses the light receiving element.

### [Background Art]

In the related art, a light receiving element in which a plurality of pixels each having a photoelectric conversion unit that detects light from an object are disposed is used. This light receiving element is used, for example, in a distance measuring device that measures a distance to an object. Measurement of a distance to an object can be performed by radiating light from an attached light source to the object to detect the light reflected from the object, and measuring the time the light from the light source takes to reciprocate the distance between the light source and the object. A light receiving element used for measuring the distance to such an object needs to detect light with high sensitivity and at a high speed, and as a photoelectric conversion unit, an avalanche photodiode (APD) or a single photon avalanche diode (SPAD), which are kinds of photodiodes, is used. Each of these diodes is a photodiode that performs photoelectric conversion in a state where a reverse bias voltage near a breakdown voltage is applied and is capable of high-sensitivity and high-speed response.

As such a light receiving element, for example, a photodetector in which the APD is disposed in each pixel as a photoelectric conversion unit, a separation region for separating the adjacent pixels is provided, and a hole accumulation region is disposed in a side wall of the separation region is used (see, for example, PTL 1). Electrons emitted from an interface state formed on an end surface of a semiconductor substrate at a boundary between the pixels are captured by the hole accumulation region, and thus it is possible to reduce a dark current caused by the electrons from the interface state. Here, the dark current is a current based on electric charges generated regardless of incident light and causes an error (noise) in a sensor output.

### [Citation List]

### [Patent Literature]

[PTL 1]
JP 2018-201005A

### [Summary]

### [Technical Problem]

The above-mentioned related art has a problem of causing crosstalk. The above-mentioned separation region reduces crosstalk by blocking light obliquely incident from adjacent pixels. However, since the separation region is formed on the semiconductor substrate, in a case where the incident light or the light generated through spontaneous light emission from the photoelectric conversion unit is reflected by the wiring layer adjacent to the semiconductor substrate and is incident on the adjacent pixels, it is not possible to block the light, which causes crosstalk. Therefore, the above-mentioned related art has a problem that a malfunction occurs due to noise.

The present disclosure has been made in view of the above-mentioned problems, and an object the present disclosure is to reduce crosstalk.

### [Solution to Problem]

The present disclosure has been made to solve the above-mentioned problems, and a first aspect thereof is a light receiving element including: pixels having photoelectric conversion units, each photoelectric conversion unit being disposed in a semiconductor substrate to perform photoelectric conversion of incident light; a wiring region having a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate; and a separation region that is disposed in the semiconductor substrate at a boundary between the pixels, is formed in a shape which penetrates the semiconductor substrate and in which a width on the front surface side is wider than a width on the back surface side, and separates the photoelectric conversion units from each other.

Further, in the first aspect, the separation region may be formed in a wall shape which surrounds the photoelectric conversion unit and may be formed in a shape in which a width in a direction parallel to the surface of the semiconductor substrate is wider on the front surface side than on the back surface side.

Further, in the first aspect, the separation region may include a wiring region adjacent portion that is disposed adjacent to the wiring region and is formed to have a width wider than the width on the front surface side.

Further, in the first aspect, the separation region may include the wiring region adjacent portion formed to have a cross section of a reverse taper shape.

Further, in the first aspect, the separation region may include the wiring region adjacent portion formed to have a cross section of a hemispherical shape.

Further, in the first aspect, the separation region may include the wiring region adjacent portion formed from the front surface side of the semiconductor substrate.

Further, in the first aspect, the separation region may be formed in a shape adjacent to the wiring layer.

The first aspect may further include: a wiring layer protective film disposed between the separation region and the wiring layer, wherein the separation region may be adjacent to the wiring layer via the wiring layer protective film.

Further, in the first aspect, the separation region may be formed to be disposed in a groove portion formed in the semiconductor substrate.

Further, in the first aspect, the separation region may be disposed in the groove portion having a shape in which the width on the front surface side of the semiconductor substrate is wider than the width on the back surface side thereof.

Further, in the first aspect, the separation region may be formed by disposing a metal in the groove portion.

Further, in the first aspect, the separation region may further include an insulating film disposed between the semiconductor substrate and the separation region.

Further, in the first aspect, the separation region may include the insulating film formed to have a shape in which a film thickness on the front surface side of the semiconductor substrate is thicker than a film thickness on the back surface side thereof.

Further, in the first aspect, the photoelectric conversion unit may be constituted by a photodiode.

Further, in the first aspect, the photoelectric conversion unit may be constituted by the photodiode that multiplies charges generated through photoelectric conversion of the incident light with a high reverse bias voltage.

Further, in the first aspect, in the photoelectric conversion unit, the generated charges may be multiplied in a pn junction constituted by a p-type semiconductor region and an n-type semiconductor region.

Further, in the first aspect, the photoelectric conversion unit may include a cathode region constituted by the n-type semiconductor region.

Further, in the first aspect, the photoelectric conversion unit may include the cathode region disposed on the front surface side of the semiconductor substrate.

Further, in the first aspect, the separation region may include a wiring region adjacent portion which is adjacent to the wiring region and is formed to have a width wider than the width on the back surface side, the wiring region adjacent portion being disposed in a region closer to the wiring region than to a region in which the charges are multiplied in the photodiode.

Further, in the first aspect, in the photoelectric conversion unit, the generated charges may be multiplied in a pn junction constituted by a p-type semiconductor region and an n-type semiconductor region, and the separation region may include the wiring region adjacent portion formed to have a height lower than that of a region of the pn junction from the front surface side of the semiconductor substrate.

Further, in the first aspect, the photoelectric conversion unit may include an anode region disposed in the vicinity of the separation region on the front surface side of the semiconductor substrate.

Further, in the first aspect, the wiring region may include the wiring layer which is disposed in the vicinity of the separation region and is connected to the anode region.

Further, a second aspect of the present disclosure is electronic equipment including: pixels having photoelectric conversion units, each photoelectric conversion unit being disposed in a semiconductor substrate to perform photoelectric conversion of incident light; a wiring region having a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate; a separation region that is disposed in the semiconductor substrate at a boundary between the pixels, is formed in a shape which penetrates the semiconductor substrate and in which a width on the front surface side is wider than a width on the back surface side, and separates the photoelectric conversion units from each other; and a processing circuit that performs processing for a signal generated on the basis of the photoelectric conversion.

Further, in the second aspect, the photoelectric conversion unit may perform photoelectric conversion of the incident light that is incident on it, the incident light being obtained by light emitted from a light source being reflected by a subject, and the processing circuit may perform the processing for measuring a distance to the subject by measuring a time from radiation of the light from the light source to generation of the signal.

Further, in the second aspect, the processing circuit may perform the processing for detecting an amount of change in the signal.

Further, in the second aspect, the processing circuit may detect the amount of change by comparing with a predetermined threshold value.

Further, in the second aspect, the processing circuit may be disposed on a semiconductor substrate bonded to the semiconductor substrate.

According to the aspects of the present disclosure, it is possible to obtain an effect that the separation region having a shape in which the width in the vicinity of the wiring region is wider than that on the back surface side of the semiconductor substrate is disposed. It is assumed that light blocking is performed by the separation region having the wider width.

### [Brief Description of Drawings]

[Fig. 1]

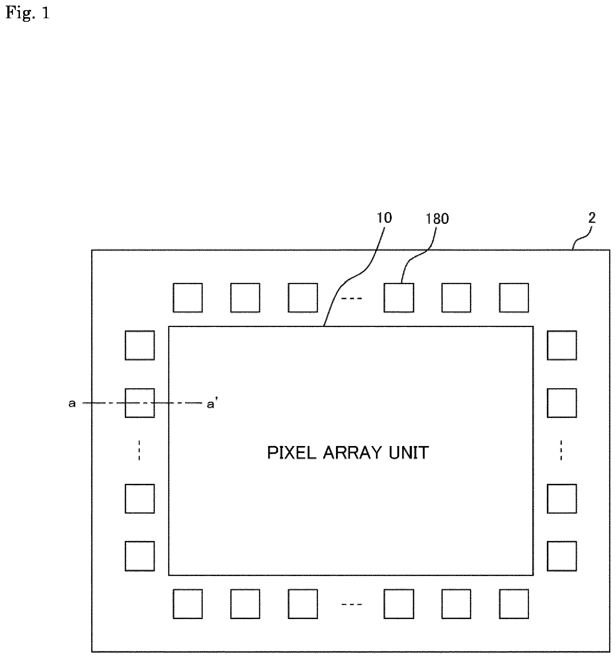

   Fig. 1 is a view showing a configuration example of a light receiving element according to a first embodiment of the present disclosure.
[Fig. 2]

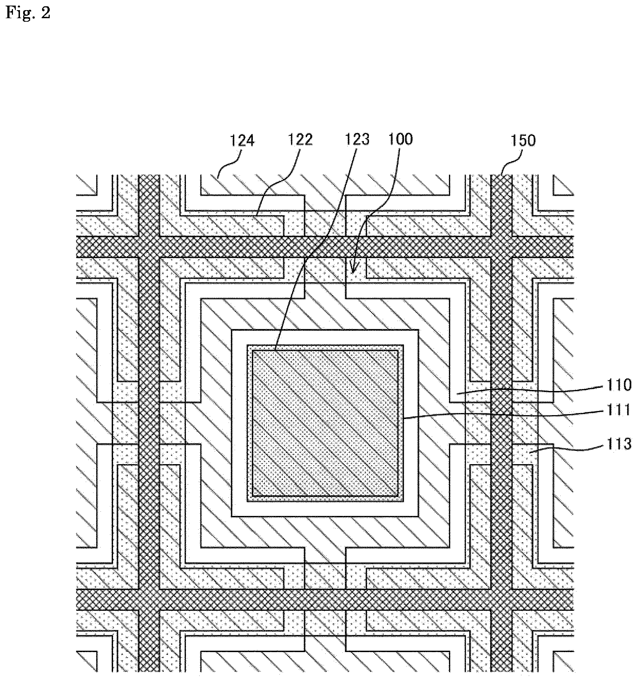

   Fig. 2 is a view showing a configuration example of a pixel according to the first embodiment of the present disclosure.
[Fig. 3]

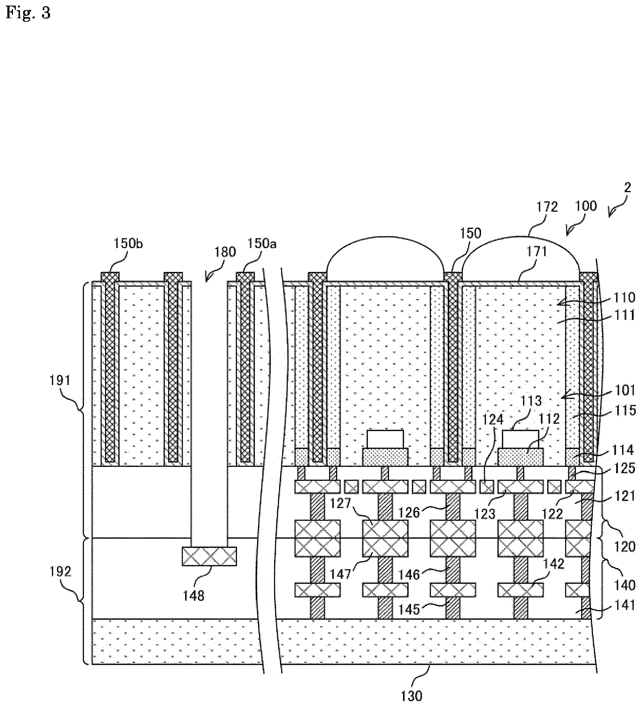

   Fig. 3 is a cross-sectional view showing the configuration example of the pixel according to the first embodiment of the present disclosure.
[Fig. 4]

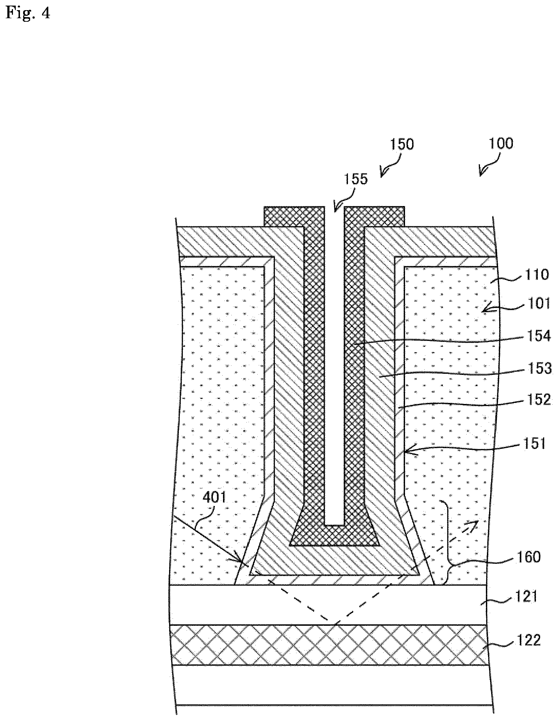

   Fig. 4 is a cross-sectional view showing a configuration example of a separation region according to the first embodiment of the present disclosure.
[Fig. 5]

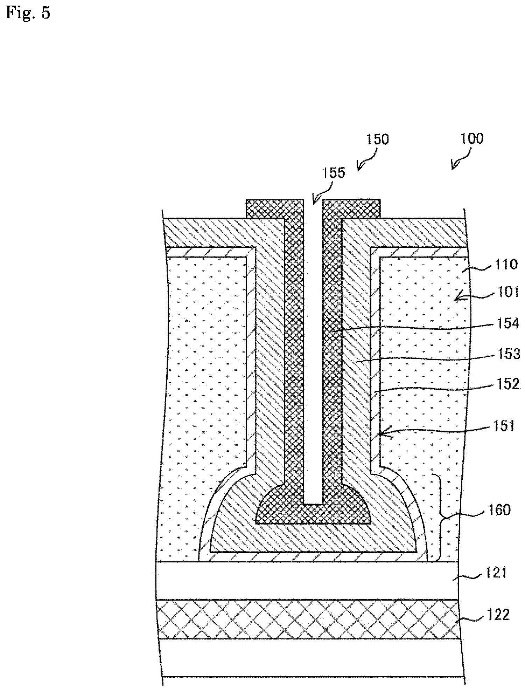

   Fig. 5 is a cross-sectional view showing another configuration example of the separation region according to the first embodiment of the present disclosure.
[Fig. 6]

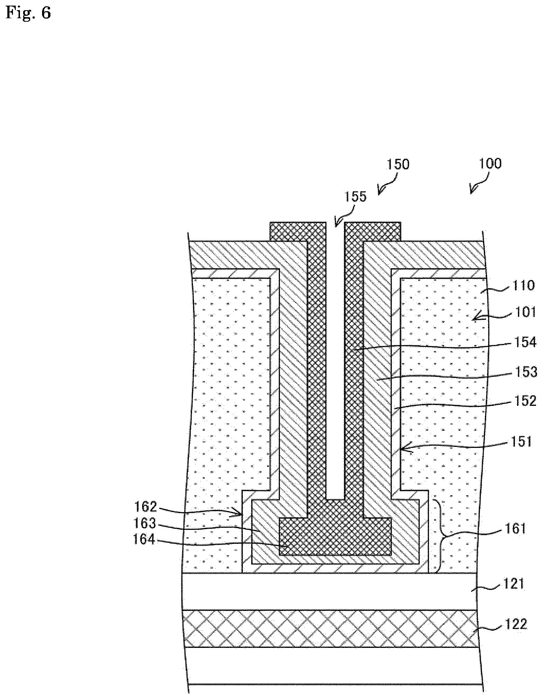

   Fig. 6 is a cross-sectional view showing a configuration example of a separation region according to a second embodiment of the present disclosure.
[Fig. 7]

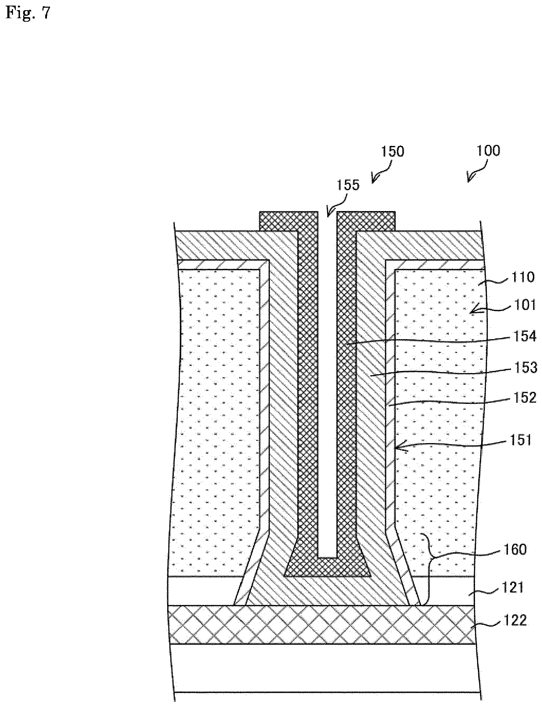

   Fig. 7 is a cross-sectional view showing a configuration example of a separation region according to a third embodiment of the present disclosure.
[Fig. 8]

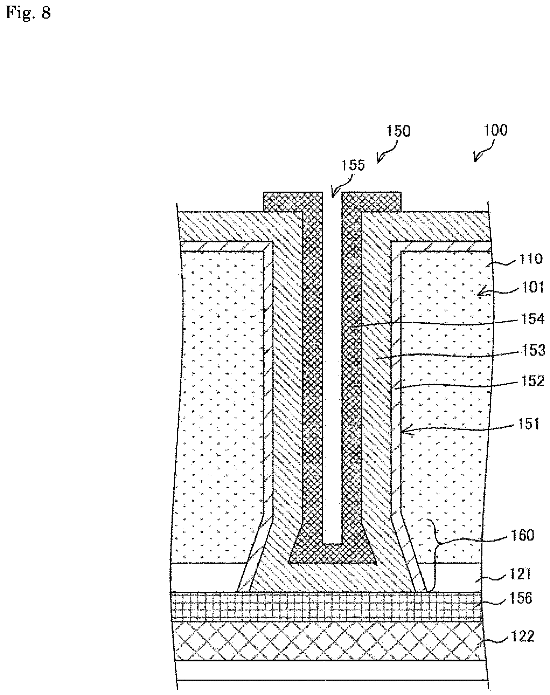

   Fig. 8 is a cross-sectional view showing another configuration example of the separation region according to the third embodiment of the present disclosure.
[Fig. 9]

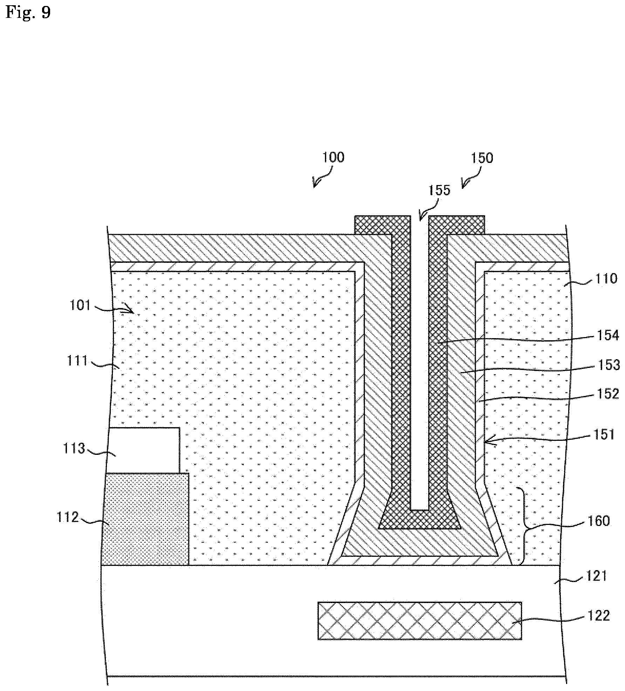

   Fig. 9 is a cross-sectional view showing a configuration example of a separation region according to a fourth embodiment of the present disclosure.
[Fig. 10]

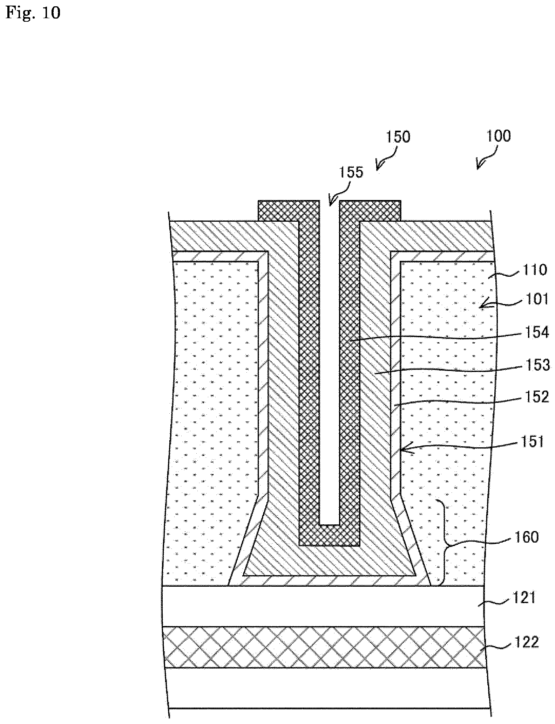

   Fig. 10 is a cross-sectional view showing a configuration example of a separation region according to a modification example of the embodiment of the present disclosure.
[Fig. 11]

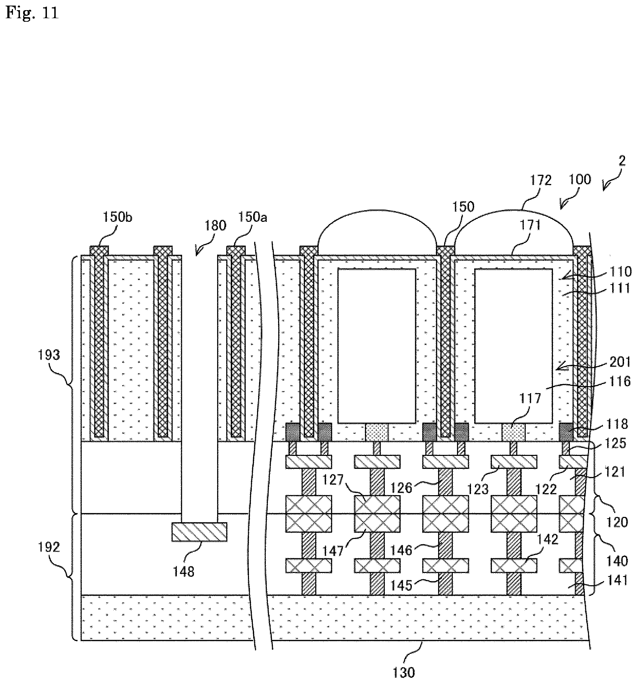

   Fig. 11 is a cross-sectional view showing a configuration example of a pixel according to a fifth embodiment of the present disclosure.
[Fig. 12]

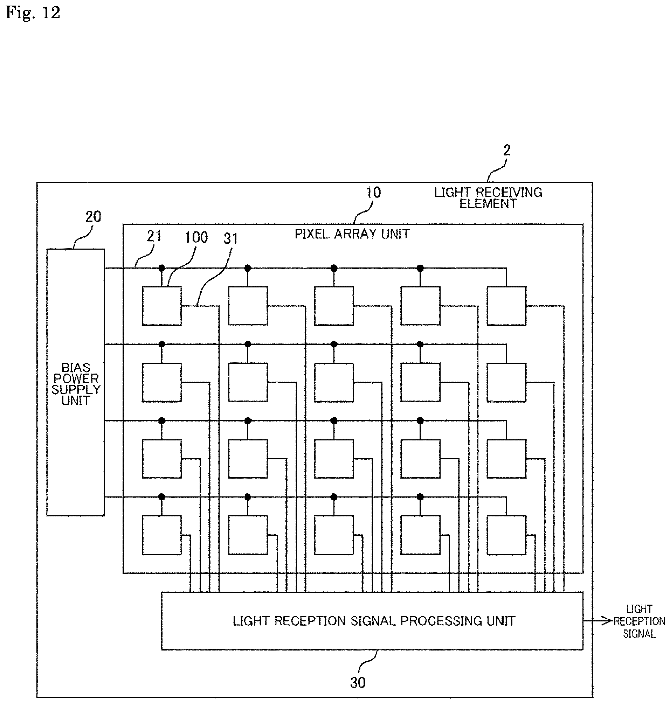

   Fig. 12 is a diagram showing a configuration example of a light receiving element according to a distance measuring device to which the technology according to the present disclosure can be applied.
[Fig. 13]

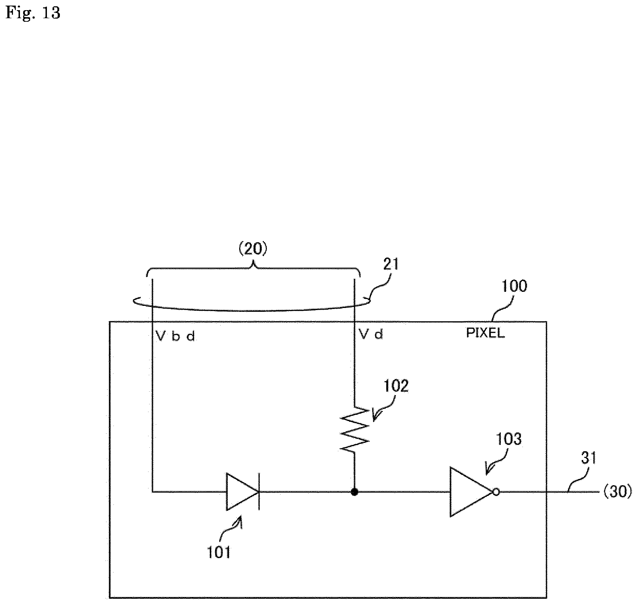

   Fig. 13 is a circuit diagram showing a configuration example of a pixel according to the distance measuring device to which the technology according to the present disclosure can be applied.
[Fig. 14]

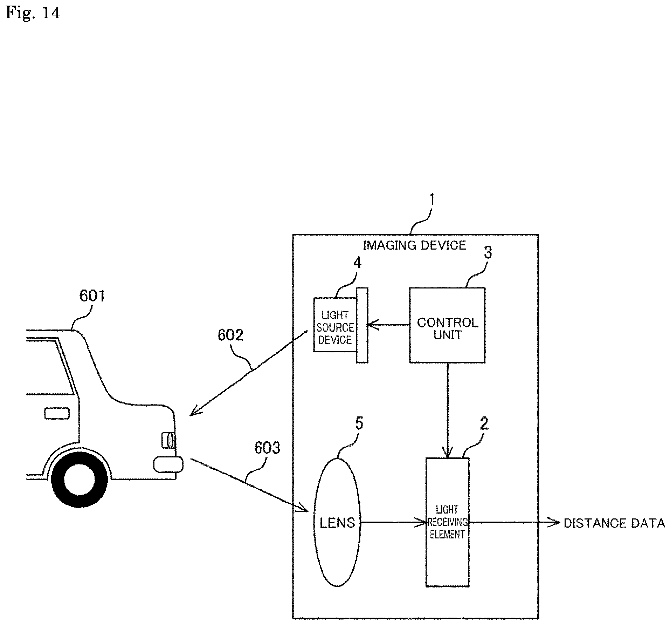

   Fig. 14 is a diagram showing a configuration example of an imaging device according to the distance measuring device to which the technology according to the present disclosure can be applied.
[Fig. 15]

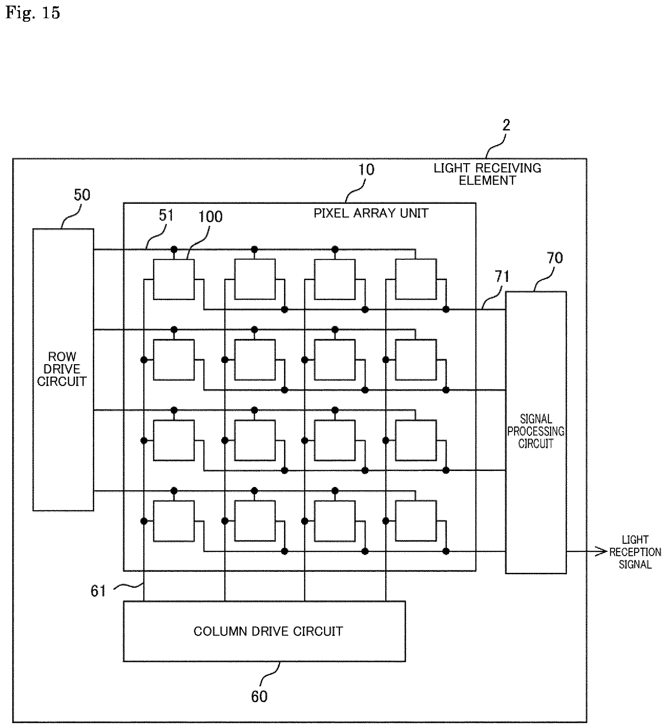

   Fig. 15 is a diagram showing a configuration example of a light receiving element according to a DVS to which the technology according to the present disclosure can be applied.
[Fig. 16]

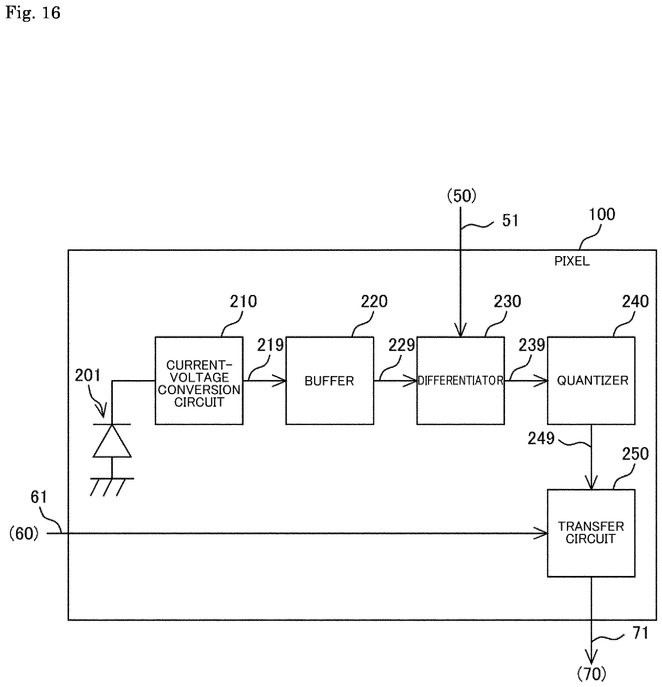

   Fig. 16 is a diagram showing a configuration example of a pixel according to the DVS to which the technology according to the present disclosure can be applied.
[Fig. 17]

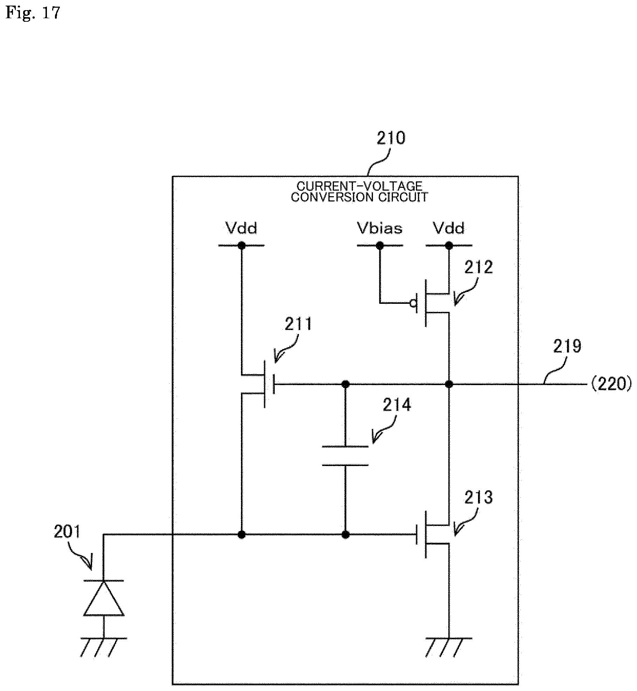

   Fig. 17 is a diagram showing a configuration example of a current-voltage conversion circuit according to the DVS to which the technology according to the present disclosure can be applied.
[Fig. 18]

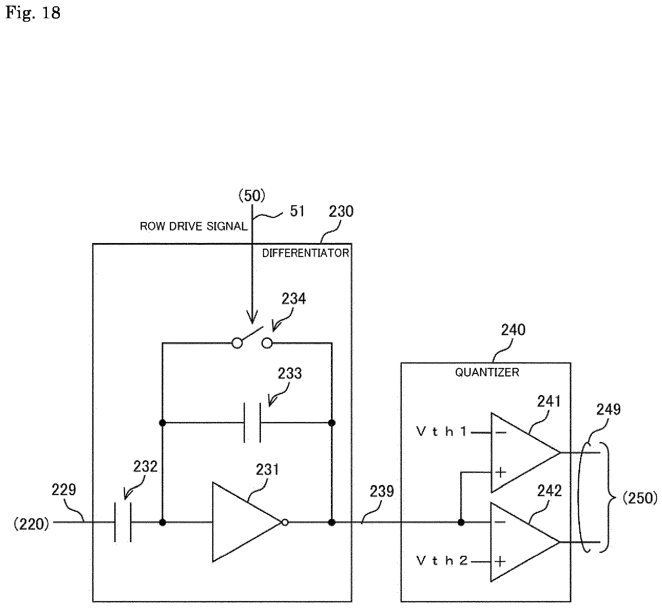

   Fig. 18 is a view showing a configuration example of a differentiator and a quantizer according to the DVS to which the technology according to the present disclosure can be applied.
[Fig. 19]

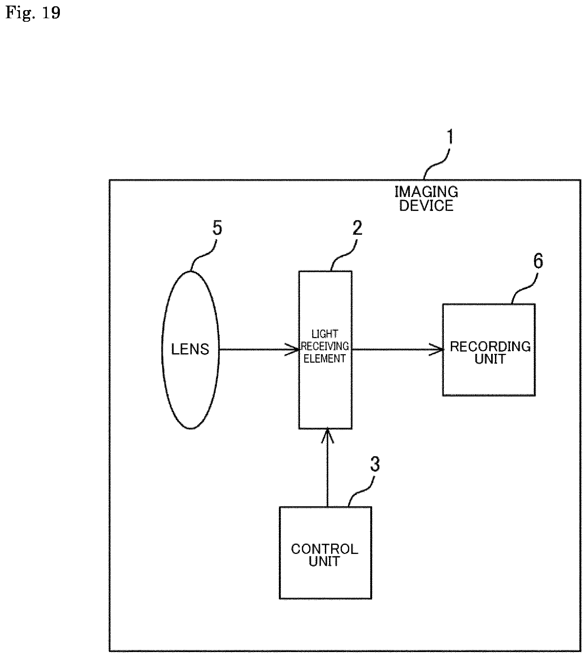

   Fig. 19 is a diagram showing a configuration example of an imaging device according to the DVS to which the technology according to the present disclosure can be applied.

### [Description of Embodiments]

Next, embodiments for implementing the present disclosure (hereinafter referred to as embodiments) will be described with reference to the drawings. In the following drawings, the same or similar portions are denoted by the same or similar reference signs. In addition, the embodiments will be described in the following order.
1. First Embodiment
2. Second Embodiment
3. Third Embodiment
4. Fourth Embodiment
5. Modification Example
6. Fifth Embodiment
7. Application Example to Distance Measuring Device
8. Application Example to DVS

### <1. First Embodiment>

### [Configuration of Light Receiving Element]

Fig. 1 is a view showing a configuration example of a light receiving element according to a first embodiment of the present disclosure. The figure is a plan view showing the configuration example of the light receiving element 2 and is a plan view showing the configuration of a light receiving surface of the light receiving element 2 which is a surface irradiated with incident light.

A pixel array unit 10 is disposed on the light receiving surface of the light receiving element 2. This pixel array unit 10 is a region which is disposed in the central portion of the light receiving element 2 and in which pixels for detecting the incident light (pixels 100 which will be described later) are disposed in a two-dimensional grid shape. A photoelectric conversion unit (a photoelectric conversion unit 101 which will be described later) that performs photoelectric conversion of the incident light is disposed in the pixel 100. Alight reception signal corresponding to the electric charges generated through the photoelectric conversion by this photoelectric conversion unit 101 is generated and is output from the pixel 100. The incident light can be detected with this light reception signal. Further, a plurality of pad openings 180 are disposed at the end portion of the light receiving element 2. An electrode pad (an electrode pad 148 which will be described later) is disposed at the bottom of each of these pad openings 180. As will be described later, the light receiving element 2 is configured by bonding two semiconductor chips to each other.

### [Configuration of Pixel]

Fig. 2 is a view showing a configuration example of a pixel according to the first embodiment of the present disclosure. The figure is a plan view showing the configuration example of the pixel 100. In the pixel 100 in the figure, semiconductor regions (semiconductor regions 111 and 113) formed in a semiconductor substrate 110, a separation region 150 that is disposed at a boundary between the pixels 100 and has a shape which penetrates the semiconductor substrate 110, and wiring layers 122 to 124 are described. As will be described later, the separation region 150 can be formed in a wall shape. In the figure, a region with dot hatching represents the semiconductor region 111 and the like, and a region with hatched diagonal lines represents the wiring layer 122 and the like.

The semiconductor region 111 is disposed in the central portion of the pixel 100 and constitutes a cathode region. The semiconductor region 113 is disposed in a peripheral edge portion of the pixel 100 and constitutes an anode region. The wiring layer 122 constitutes an anode wiring and is connected to the semiconductor region 113. The wiring layer 123 constitutes a cathode wiring and is connected to the semiconductor region 111. The wiring layer 124 is a ground wire for shielding. This shielding suppresses the influence of electrical noise. This wiring layer 124 is disposed in a region between the wiring layers 122 and 123.

### [Configuration of Cross Section of Pixel]

Fig. 3 is a cross-sectional view showing the configuration example of the pixel according to the first embodiment of the present disclosure. The figure is a cross-sectional view along the line a-a' in Fig. 1 and is a cross-sectional view showing the configuration example of the light receiving element 2 and the pixel 100. Further, as shown in the figure, the light receiving element 2 is configured by bonding a sensor chip 191 and a logic chip 192 to each other. The sensor chip 191 is a semiconductor chip in which the photoelectric conversion unit 101, which will be described later, is disposed. The logic chip 192 is a semiconductor chip in which a processing circuit for processing a signal generated by the photoelectric conversion unit 101 is disposed.

The pixel 100 in the figure includes the semiconductor substrate 110, a wiring region 120, a semiconductor substrate 130, a wiring region 140, the separation region 150, a protective film 171 and an on-chip lens 172. The semiconductor substrate 110, an insulating layer 121, and the wiring layers 122 to 124 are disposed in the sensor chip 191. The semiconductor substrate 130, an insulating layer 141, and a wiring layer 142 are disposed in the logic chip 192.

The semiconductor substrate 110 is a semiconductor substrate in which the photoelectric conversion unit 101 that performs photoelectric conversion of the incident light is disposed. As this semiconductor substrate 110, for example, a semiconductor substrate formed of silicon (Si) can be used. The photoelectric conversion unit 101 in the figure shows an example constituted by an SPAD. This photoelectric conversion unit 101 is constituted by a well region 111 of the semiconductor substrate 110 and an n-type semiconductor region 112, the p-type semiconductor region 113, and a semiconductor region 114 disposed in the well region 111. The n-type semiconductor region 112 constituting the cathode region constitutes a pn junction together with the p-type semiconductor region 113. A reverse bias voltage is applied to this pn junction via the well region 111 to form a depletion layer.

The photoelectric conversion of the photoelectric conversion unit 101 in the figure is performed in the well region 111. When the electrons of the charges generated by the photoelectric effect reach the depletion layer of the pn junction by drifting, the electrons are accelerated by the electric field based on the reverse bias voltage. A reverse bias voltage exceeding a breakdown voltage is applied to the photoelectric conversion unit 101 constituting the SPAD. Specifically, a reverse bias voltage of about 20 V is applied. The strong electric field due to this reverse bias voltage causes electron avalanche, and electron avalanche occurs continuously, and thus the charges increase sharply. Therefore, the photoelectric conversion unit 101 can detect the incidence of a single photon. By disposing such a photoelectric conversion unit 101, it is possible to make a high-sensitivity pixel 100. A region near the pn junction at an interface between the semiconductor regions 112 and 113 is a region in which charge multiplication is performed and is referred to as a multiplication region. The p-type semiconductor region 114 is disposed adjacent to the well region 111 and constitutes an anode region. This p-type semiconductor region 114 is formed in a shape which surrounds the well region 111 near the n-type semiconductor region 112.

The semiconductor substrate 110 is configured to have a relatively thick film thickness. This is to improve the sensitivity of the photoelectric conversion unit 101 by forming the well region 111 constituting the SPAD thickly. The semiconductor substrate 110 can be formed to have a thickness of, for example, several pm. This well region 111 is disposed on a back surface side of the semiconductor substrate 110, and the incident light is incident from a back surface of the semiconductor substrate 110. The back surface of this semiconductor substrate 110 corresponds to a light incidence surface. On the other hand, the wiring region 120, which will be described later, is disposed on a front surface which is a surface opposite to the back surface of the semiconductor substrate 110. The semiconductor regions 112 and 114 constituting the cathode region and the anode region, respectively, are disposed on a front surface side of the semiconductor substrate 110.

The configuration of the photoelectric conversion unit 101 is not limited to this example. For example, the conductive types of the semiconductor regions 112, 113, and 114 may be interchanged with each other. Specifically, a configuration using the p-type semiconductor region 112 and the n-type semiconductor regions 113 and 114 can be adopted. In this case, the semiconductor region 112 becomes the anode region, and the semiconductor region 114 becomes the cathode region. Further, a hole accumulation region 115, which will be described later, is changed to an electron accumulation region 115. This electron accumulation region 115 is a region which is formed of the n-type semiconductor to accumulate electrons. The conductive type of the semiconductor region may be described as a first conductive type and a second conductive type instead of the p-type and the n-type.

The hole accumulation region 115 can be disposed in the semiconductor substrate 110 adjacent to the separation region 150 which will be described later. This hole accumulation region 115 captures electrons emitted from an interface state formed on an end surface of the semiconductor substrate. The hole accumulation region 115 can be constituted by the p-type semiconductor region. The electrons from the interface state are captured by recombination with holes accumulated in the hole accumulation region 115. By disposing this hole accumulation region 115, it is possible to reduce a dark current caused by the electrons from the interface state. In addition, if the electrons from the interface state are accelerated and multiplied, a malfunction occurs. By disposing the hole accumulation region 115, it is possible to prevent the dark current or the malfunction from occurring. The hole accumulation region 115 in the figure is disposed adjacent to the semiconductor region 114 constituting an anode and is electrically connected to the anode. The hole accumulation region may be further disposed at an interface on the back surface side of the semiconductor substrate 110.

The wiring region 120 is a region which is disposed on the front surface side of the semiconductor substrate 110 and in which a wiring for transmitting a signal to the photoelectric conversion unit 101 or the like is disposed. The insulating layer 121 and the wiring layers 122 to 124 are disposed in this wiring region 120. The wiring layers 122 to 124 are wirings for transmitting a signal and the like from the photoelectric conversion unit 101. This wiring layer 122 and the like can be formed of a metal such as copper (Cu). The insulating layer 121 insulates the wiring layer 122 and the like from each other. This insulating layer 121 can be formed of, for example, silicon oxide (SiO₂). A contact plug 125 for connecting the semiconductor region of the semiconductor substrate 110 and the wiring layer 122 to each other is further disposed in this wiring region 120. The wiring layer 122 is connected to the semiconductor region 114 constituting the anode region of the photoelectric conversion unit 101 via the contact plug 125. Similarly, the wiring layer 123 is connected to the semiconductor region 112 constituting the cathode region. The contact plug 125 can be formed of, for example, tungsten (W). Further, the wiring layer 122 in the figure shows an example in which the wiring layer 122 is disposed in the wiring region 120 directly below the separation region 150.

A pad 127 and a via plug 126 are further disposed in the wiring region 120. The pad 127 is an electrode disposed in the front surface of the wiring region 120. This pad 127 can be formed of, for example, Cu. The via plug 126 connects the wiring layer 122 and the like and the pad 127 to each other. This via plug 126 can be formed of, for example, Cu. The figure shows an example in which the wiring layers 122 to 124 are disposed in the same layer of the wiring region 120. It is possible to adopt a configuration having a plurality of wiring layers for the wiring region 120, and it is also possible to dispose the wiring layers 122 to 124 in different layers of the wiring region 120. The wirings disposed in the different layers can be connected by a via plug.

The semiconductor substrate 130 is a semiconductor substrate bonded to the semiconductor substrate 110. A diffusion region of an element such as a processing circuit that processes a signal generated by the photoelectric conversion unit 101 can be formed in this semiconductor substrate 130.

The wiring region 140 is a wiring region disposed on a front surface side of the semiconductor substrate 130. The wiring layer 142 and the insulating layer 141 are disposed in the wiring region 140. A pad 147 is disposed in a front surface of the wiring region 140 and is connected to the wiring layer 142 by a via plug 146. Further, the wiring layer 142 and the semiconductor substrate 130 are connected to each other by a contact plug 145. When the sensor chip 191 is bonded to the logic chip 192, the pad 147 and the pad 127 are joined to each other. A signal can be exchanged between the elements disposed in the semiconductor substrates 110 and 130 via the pads 147 and 127. It is possible to configure a wiring that connects the photoelectric conversion unit and the above-mentioned processing circuit. In this way, the wiring that electrically connects the photoelectric conversion unit 101 and the circuit to each other can be disposed in the wiring regions 120 and 140. Further, the wiring layers constituting an optical shield that reflects the incident light transmitted through the semiconductor substrate 110 and causes the incident light to enter the semiconductor substrate 110 again can be disposed in the wiring regions 120 and 140.

The separation region 150 is disposed in the semiconductor substrate 110 at the boundary between the pixels 100 to separate the photoelectric conversion units 101 from each other. This separation region 150 is formed in a wall shape which surrounds the pixel 100 to separate the photoelectric conversion units 101 of the adjacent pixels 100 from each other. Further, the separation region 150 is formed in a shape of a wall in which a width in a direction parallel to a surface of the semiconductor substrate 110 is wider on the front surface side than on the back surface side. Further, the separation region 150 further blocks the incident light. The incident light obliquely incident through the adjacent pixels 100 is blocked by the separation region 150. As a result, it is possible to reduce the occurrence of crosstalk. As described in Fig. 2, the separation regions 150 are disposed in a grid shape. The separation region 150 can be formed by embedding a metal film of W, aluminum (Al), or the like in a groove portion formed through the semiconductor substrate 110.

The protective film 171 is disposed on the back surface side of the semiconductor substrate 110 to protect the semiconductor substrate 110. This protective film 171 can be formed of, for example, SiO₂.

A fixed charge film may be disposed between the semiconductor substrate 110 and the protective film 171. This fixed charge film is disposed on the front surface of the semiconductor substrate 110 and has fixed charges for pinning the interface state of the semiconductor substrate 110. The fixed charge film can be formed of, for example, hafnium oxide (HfO₂), aluminum oxide (Al₂O₃), zirconium oxide (ZrO₂), tantalum oxide (Ta₂O₅), and titanium oxide (TiO₂).

The fixed charge film can also be disposed in the groove portion of the semiconductor substrate 110 in which the separation region 150 is disposed. Further, an insulating film that insulates the separation regions 150 formed of a metal from each other can be disposed adjacent to the separation region 150. This insulating film may be formed at the same time when the protective film 171 described above is formed.

The on-chip lens 172 is a lens that condenses the incident light. This on-chip lens 172 is formed in a hemispherical shape, is disposed on the back surface side of the semiconductor substrate 110, and condenses the incident light on the photoelectric conversion unit 101. The on-chip lens 172 can be formed of an inorganic material such as silicon nitride (SiN) or an organic material such as an acrylic resin.

Further, the electrode pad 148 and the pad opening 180 are disposed at the end portion of the light receiving element 2. The electrode pad 148 is an electrode for transmitting a signal between the light receiving element 2 and an electronic circuit outside the light receiving element 2. This electrode pad 148 is disposed in the wiring region of the logic chip 192 and is connected to the wiring layer 142. The pad opening 180 is formed in a hole shape which penetrates the sensor chip 191 and a front surface side of the insulating layer 141 of the logic chip 192 and is formed in a shape which reaches a surface of the electrode pad 148 from the light receiving surface of the light receiving element 2. With wire bonding to the electrode pad 148 via this pad opening 180, the electrode pad 148 and the outside electronic circuit can be electrically connected to each other. The electrode pad 148 can be formed of, for example, a metal such as Al or Au.

A separation region 150a can be disposed around the pad opening 180. This separation region 150a is formed in a shape which surrounds the pad opening 180 and separates the pad openings 180 from each other. Further, a separation region 150b can be disposed in the semiconductor substrate 110 at the end portion of the sensor chip 191. This separation region 150b is a separation region disposed along an outer periphery of the semiconductor substrate 110. By disposing these separation regions 150a and 150b, it is possible to prevent moisture absorption from the end surface of the semiconductor substrate 110, and it is possible to prevent growth of cracks generated on the end surface of the semiconductor substrate 110.

The configuration of the pixel 100 is not limited to this example. For example, it is also possible to adopt a configuration in which a plurality of photoelectric conversion units are disposed in the pixel 100. In such a pixel 100, a separation region for separating the photoelectric conversion units from each other can be disposed inside the pixel 100. This separation region for separating the photoelectric conversion units from each other can be formed in a shape which penetrates the semiconductor substrate 110. Further, a separation region may be disposed between the semiconductor substrate 110 at the boundary between the plurality of photoelectric conversion units and the on-chip lens 172. This separation region is a separation region that shields a region at the boundary between the photoelectric conversion units from light and can be formed of a metal film or the like. Further, even in the pixel 100 having such a plurality of photoelectric conversion units, it is also possible to adopt a configuration in which the separation region is disposed only at the boundary between the pixels 100. Further, it is also possible to adopt a configuration in which the hole accumulation region 115 is disposed on the back surface side of the semiconductor substrate 110.

### [Configuration of Separation Region]

Fig. 4 is a cross-sectional view showing a configuration example of the separation region according to the first embodiment of the present disclosure. The figure is a cross-sectional view showing the configuration example of the separation region 150 described in Fig. 3. The details of a configuration of the separation region 150 will be described with reference to the figure.

As described above, the separation region 150 is disposed at the boundary between the pixels 100 to separate the photoelectric conversion units 101 each disposed in the semiconductor substrate 110 from each other. In the figure, the configurations of the semiconductor substrate 110 and the photoelectric conversion unit 101 are omitted. The separation region 150 in the figure is constituted by a metal film 154 disposed in a groove portion 151 formed in the semiconductor substrate 110. As described above, the metal film 154 can be formed of W or the like. The metal film 154 in the figure shows an example in which a void 155 is formed in the central portion. As shown in the figure, the groove portion 151 is formed in a shape in which the width on the front surface side of the semiconductor substrate 110 is wider than the width on the back surface side thereof.

The groove portion 151 is formed in a shape which penetrates the semiconductor substrate 110 from the back surface side to the front surface side thereof. This groove portion 151 can be formed by etching the semiconductor substrate 110 from the back surface side toward the front surface side. This etching can be performed by, for example, anisotropic dry etching.

A fixed charge film 152 is disposed on the back surface side of the semiconductor substrate 110 and a wall surface of the groove portion 151 in the figure. This fixed charge film 152 can be formed by depositing a material film such as HfO₂ through atomic layer deposition (ALD), for example.

An insulating film 153 is disposed between the fixed charge film 152 and the metal film 154. This insulating film 153 can be formed by depositing a material film such as SiO₂ through chemical vapor deposition (CVD), for example.

The groove portion 151 in the figure is formed in a shape in which the width on the front surface side and the width on the back surface side of the semiconductor substrate 110 are different. Specifically, the groove portion 151 is formed such that the width on the front surface side of the semiconductor substrate 110 is wider than the width on the back surface side thereof. Therefore, the insulating film 153 and the metal film 154 in the figure are also formed in a shape in which the width on the front surface side and the width on the back surface side are different and are also formed such that the width on the front surface side of the semiconductor substrate 110 is wider than the width on the back surface side thereof. The shape of the groove portion 151 in the figure can be formed by increasing the amount of over-etching when the vicinity of the front surface side of the semiconductor substrate 110 is etched.

In the separation region 150 in the figure, since a portion near the wiring region 120 is expanded in a direction parallel to the front surface side of the semiconductor substrate 110, light obliquely incident on the region can be blocked. Incident light 401 in the figure represents the incident light that is blocked at the bottom of the separation region 150. Hereinafter, a region of the separation region 150 which is adjacent to the wiring region 120 and is formed to have a width wider than that of the back surface side of the semiconductor substrate 110 is referred to as a wiring region adjacent portion 160. The incident light 401 is blocked by the wiring region adjacent portion 160. The blocking of the incident light 401 is performed by reflecting or absorbing the incident light by the insulating film 153 or the metal film 154. As a result, it is possible to reduce the crosstalk.

The dotted line arrow in the figure shows the locus of the incident light 401 in a case where there is no wiring region adjacent portion 160. In a case where there is no wiring region adjacent portion 160, the light obliquely incident on the bottom of the separation region 150 is reflected by the wiring layer 122 directly below the separation region 150 and is incident on the photoelectric conversion unit 101 of the adjacent pixel 100. This causes crosstalk between the adjacent pixels 100. In this way, even in a case where the wiring layer 122 or the like is disposed directly below the separation region 150, when the wiring region adjacent portion 160 is disposed in the separation region 150, the leakage of the incident light via the wiring layer 122 or the like can be reduced. The wiring region adjacent portion 160 in the figure shows an example of the wiring region adjacent portion 160 formed to have a cross section of a reverse taper shape.

The wiring region adjacent portion 160 can also be disposed in the separation regions 150a and 150b described in Fig. 3.

### [Another Configuration of Separation Region]

Fig. 5 is a cross-sectional view showing another configuration example of the separation region according to the first embodiment of the present disclosure. The figure is a cross-sectional view showing the configuration example of the separation region 150 as in Fig. 4. The separation region 150 in Fig. 5 is different from the separation region 150 in Fig. 4 in that the wiring region adjacent portion 160 is formed in a hemispherical shape.

By widening the wiring region adjacent portion 160, it is possible to widen a light blocking region, and it is possible to further reduce the crosstalk. The shape of the groove portion 151 in the figure can be formed by further increasing the amount of over-etching when the vicinity of the front surface side of the semiconductor substrate 110 is etched.

When the width of the separation region 150 on the front surface side is widened in this way, the light that leaks to the adjacent pixel 100 via the wiring layer 122 or the like can be blocked. As a result, it is possible to reduce the crosstalk.

### <2. Second Embodiment>

In the light receiving element 2 of the first embodiment described above, the separation region 150 is disposed in the groove portion 151 formed from the back surface side of the semiconductor substrate 110. On the other hand, a light receiving element 2 of a second embodiment of the present disclosure is different from that of the first embodiment described above in that the separation region 150 is disposed in a groove portion formed on the front surface side and the back surface side of the semiconductor substrate 110.

### [Configuration of Separation Region]

Fig. 6 is a cross-sectional view showing a configuration example of the separation region according to the second embodiment of the present disclosure. The figure is a cross-sectional view showing the configuration example of the separation region 150 as in Fig. 4. The separation region 150 in Fig. 6 is different from the separation region 150 described in Fig. 4 in that a wiring region adjacent portion 161 is disposed instead of the wiring region adjacent portion 160.

The wiring region adjacent portion 161 in the figure is disposed in a groove portion 162 formed from the front surface side of the semiconductor substrate 110. This groove portion 162 is formed to have a width wider than that of the groove portion 151. By embedding an insulating film 163 and a metal film 164 in this groove portion 162 in order, it is possible to form the wiring region adjacent portion 161. Next, the insulating layer 121, the wiring layer 122, and the like are formed to dispose the wiring region 120. After that, it is possible to form the separation region 150 in the figure by forming the groove portion 151 having a depth reaching the metal film 164 from the back surface side of the semiconductor substrate 110 and disposing the insulating film 153 and the metal film 154.

Since the groove portion 162 is formed in a process different from that of the groove portion 151, the groove portion 162 having an arbitrary width can be formed. A manufacturing process of the groove portion 162 of the wiring region adjacent portion 161 can be simplified as compared with the case where the groove portion 151 having various widths is formed by adjusting the amount of over-etching.

Since the configuration of the light receiving element 2 other than this is the same as the configuration of the light receiving element 2 described in the first embodiment of the present disclosure, the description thereof will be omitted.

As described above, in the light receiving element 2 of the second embodiment of the present disclosure, the groove portion 162 of the wiring region adjacent portion 161 is formed from the front surface side of the semiconductor substrate 110, and thus the manufacturing process can be simplified.

### <3. Third Embodiment>

In the light receiving element 2 of the first embodiment described above, the bottom of the separation region 150 is disposed on the front surface side of the semiconductor substrate 110. On the other hand, a light receiving element 2 of a third embodiment of the present disclosure is different from that of the first embodiment described above in that the bottom of the separation region 150 is disposed inside the wiring region 120.

### [Configuration of Separation Region]

Fig. 7 is a cross-sectional view showing a configuration example of the separation region according to the third embodiment of the present disclosure. The figure is a cross-sectional view showing the configuration example of the separation region 150 as in Fig. 4. The separation region 150 in Fig. 7 is different from the separation region 150 described in Fig. 4 in that the bottom of the separation region 150 is disposed adjacent to the wiring layer 122.

The separation region 150 in the figure has a configuration in which the insulating film 153 is disposed between the wiring layer 122 and the metal film 154. As a result, it is possible to bring the wiring region adjacent portion 161 close to the wiring layer 122 while insulating a portion between the wiring layer 122 and the metal film 154. The leakage of the incident light via the wiring layer 122 can be further reduced.

### [Another Configuration of Separation Region]

Fig. 8 is a cross-sectional view showing another configuration example of the separation region according to the third embodiment of the present disclosure. The figure is a cross-sectional view showing the configuration example of the separation region 150 as in Fig. 7. The separation region 150 in Fig. 8 is different from the separation region 150 described in Fig. 7 in that a wiring layer protective film 156 is disposed between the bottom of the separation region 150 and the wiring layer 122.

The wiring layer protective film 156 is disposed between the separation region 150 and the wiring layer 122 to protect the wiring layer 122. As described above, the groove portion 151 can be formed by etching the semiconductor substrate 110. The wiring layer protective film 156 protects the wiring layer 122 by suppressing the etching of the insulating layer 121 adjacent to the wiring layer 122 during this etching. The wiring layer protective film 156 can be formed of a member, called an etching stopper, which has a high selection ratio with respect to SiO₂ which is an object to be etched. Specifically, the wiring layer protective film 156 can be formed of silicon nitride (SiN), silicon carbide (SiC), silicon oxynitride (SiON), carbon (C), W, titanium (Ti), titanium nitride (TiN), and the like.

The separation region 150 in the figure is disposed adjacent to the wiring layer 122 via the wiring layer protective film 156.

Since the configuration of the light receiving element 2 other than this is the same as the configuration of the light receiving element 2 described in the first embodiment of the present disclosure, the description thereof will be omitted.

As described above, in the light receiving element 2 of the third embodiment of the present disclosure, the separation region 150 is disposed adjacent to the wiring layer 122. As a result, the leakage of incident light via the wiring layer 122 can be further reduced.

### <4. Fourth Embodiment>

In the light receiving element 2 of the first embodiment described above, the wiring region adjacent portion 160 is disposed at the bottom of the separation region 150. On the other hand, a light receiving element 2 of a fourth embodiment of the present disclosure is different from that of the first embodiment described above in that the region of the wiring region adjacent portion 160 is limited.

### [Configuration of Separation Region]

Fig. 9 is a cross-sectional view showing a configuration example of the separation region according to the fourth embodiment of the present disclosure. The figure is a cross-sectional view showing the configuration example of the separation region 150 as in Fig. 4. The separation region 150 in Fig. 9 is different from the separation region 150 in Fig. 4 in that the wiring region adjacent portion 160 is disposed in a region closer to the wiring region 120 than to the charge multiplication region in the photoelectric conversion unit 101. In the figure, the description of the semiconductor region 114 and the hole accumulation region 115 is omitted.

The wiring region adjacent portion 160 in the figure can be formed such that the height from the front surface side of the semiconductor substrate 110 is lower than the semiconductor region 113 of the photoelectric conversion unit 101 constituting the SPAD. Specifically, the wiring region adjacent portion 160 can be formed to have a height lower than an interface on a side of the semiconductor region 113 on which the incident light is incident, preferably, a height lower than a region of the pn junction at the interface between the semiconductor regions 112 and 113. As described above, the n-type semiconductor region 112 constituting the cathode region and the p-type semiconductor region 113 constitute the pn junction. When a reverse bias voltage is applied to this pn junction, a depletion layer is formed in the region of the semiconductor region 113, and the charge multiplication is performed. When the wiring region adjacent portion 160 is disposed in the vicinity of such a multiplication region, the semiconductor region that contributes to the charge multiplication becomes narrow. Therefore, the sensitivity of the pixel 100 is lowered. Therefore, by forming the wiring region adjacent portion 160 in a shape that does not overlap the multiplication region, it is possible to prevent a decrease in the sensitivity of the pixel 100.

Since the configuration of the light receiving element 2 other than this is the same as the configuration of the light receiving element 2 described in the first embodiment of the present disclosure, the description thereof will be omitted.

As described above, in the light receiving element 2 of the fourth embodiment of the present disclosure, by disposing the wiring region adjacent portion 160 closer to the wiring region 120 than to the multiplication region of the photoelectric conversion unit 101, it is possible to prevent a decrease in the sensitivity of the pixel 100.

### <5. Modification Example>

The light receiving element 2 of the first embodiment described above is formed such that the width of the metal film 154 of the separation region 150 on the front surface side of the semiconductor substrate 110 is wider than that on the back surface side thereof, but the light receiving element 2 may be formed such that the width on the front surface side is the same as that on the back surface side.

### [Configuration of Separation Region]

Fig. 10 is a cross-sectional view showing a configuration example of a separation region according to a modification example of the embodiment of the present disclosure. The figure is a cross-sectional view showing the configuration example of the separation region 150 as in Fig. 4. The separation region 150 in Fig. 10 is different from the separation region 150 in Fig. 4 in that the metal film 154 formed to have the same width on the front surface side and the back surface side of the semiconductor substrate 110 is disposed. Further, the insulating film 153 is formed to have a shape in which a film thickness on the front surface side is thicker than a film thickness on the back surface side. Although not shown, the metal film 154 may have a configuration in which the width of the front surface side of the semiconductor substrate 110 is narrower than that of the back surface side thereof.

Since the configuration of the light receiving element 2 other than this is the same as the configuration of the light receiving element 2 described in the first embodiment of the present disclosure, the description thereof will be omitted.

### <6. Fifth Embodiment>

In the light receiving element 2 of the first embodiment described above, the photoelectric conversion unit 101 constituted by the photodiode such as the SPAD or the APD which multiplies the charges generated through photoelectric conversion with a reverse bias voltage is used. On the other hand, the light receiving element 2 of the fifth embodiment of the present disclosure is different from that of the first embodiment described above in that a photoelectric conversion unit constituted by a normal photodiode is used.

### [Configuration of Cross Section of Pixel]

Fig. 11 is a cross-sectional view showing a configuration example of a pixel according to a fifth embodiment of the present disclosure. The figure is a cross-sectional view showing the configuration example of the pixel 100 as in Fig. 3. The pixel 100 in Fig. 11 is different from the pixel 100 in Fig. 3 in that a photoelectric conversion unit 201 constituted by a photodiode is disposed.

The photoelectric conversion unit 201 in the figure is constituted by a p-type well region 111 of the semiconductor substrate 110 and an n-type semiconductor region 116 disposed in the well region 111. A photodiode formed by a pn junction at an interface between the n-type semiconductor region 116 and the surrounding p-type well region 111 corresponds to the photoelectric conversion unit 201. The well region 111 and the semiconductor region 116 constitute an anode region and a cathode region, respectively.

Further, a semiconductor region 117 and a semiconductor region 118 are further disposed in the semiconductor substrate 110 in the figure. The semiconductor region 117 is an n-type semiconductor region formed to have a relatively high impurity concentration and is a semiconductor region disposed adjacent to the semiconductor region 116 and electrically connected thereto. The contact plug 125 is connected to the semiconductor region 117. The semiconductor region 118 is an p-type semiconductor region formed to have a relatively high impurity concentration and is a semiconductor region disposed adjacent to the well region and electrically connected thereto. The contact plug 125 is also connected to the semiconductor region 118. The semiconductor region 118 is a semiconductor region constituting a so-called well contact.

The wiring layers 122 and 123 are disposed in the wiring region 120. The wiring layer 122 is connected to the well region 111 constituting the anode region via the contact plug 125 and the semiconductor region 118. The wiring layer 123 is connected to the semiconductor region 116 constituting the cathode region via the contact plug 125 and the semiconductor region 117. Further, the wiring layer 124 is omitted.

Also in the separation region 150 of the figure, the wiring region adjacent portion 160 and the wiring layer protective film 156 described in Fig. 4 are disposed, and the crosstalk is reduced.

Since the configuration of the light receiving element 2 other than this is the same as the configuration of the light receiving element 2 described in the first embodiment of the present disclosure, the description thereof will be omitted.

As described above, in the light receiving element 2 of the fifth embodiment of the present disclosure, in a case where the photoelectric conversion unit 101 constituted by the photodiode is used, by widening the width of the separation region 150 on the front surface side, it is possible to block the light that leaks to the adjacent pixel 100. As a result, it is possible to reduce the crosstalk.

### <7. Application Example to Distance Measuring Device>

The technology according to the present disclosure can be applied to various products. For example, the technology according to the present disclosure may be applied to a distance measuring device. Here, the distance measuring device is a device that measures a distance to the object.

### [Configuration of Light Receiving Element]

Fig. 12 is a diagram showing a configuration example of a light receiving element according to the distance measuring device to which the technology according to the present disclosure can be applied. The light receiving element 2 in the figure includes a pixel array unit 10, a bias power supply unit 20, and a light reception signal processing unit 30.

The pixel array unit 10 is configured by disposing a plurality of pixels 100 each having a photoelectric conversion unit that performs photoelectric conversion of the incident light in a two-dimensional grid shape. This pixel 100 detects the incident light and outputs a light reception signal as a detection result. For example, the APD or the SPAD can be used for the photoelectric conversion unit. Hereinafter, it is assumed that the SPAD is disposed in the pixel 100 as the photoelectric conversion unit. Signal lines 21 and 31 are connected to each pixel 100. The signal line 21 is a signal line through which a bias voltage of the pixel 100 is supplied. The signal line 31 is a signal line through which a light reception signal from the pixel 100 is transmitted. In the pixel array unit 10 in the figure, an example in which the pixels 100 are disposed in 4 rows and 5 columns is described, but the number of pixels 100 disposed in the pixel array unit 10 is not limited to the example.

The bias power supply unit 20 is a power source that supplies a bias voltage to the pixel 100. The bias power supply unit 20 supplies a bias voltage via the signal line 21.

The light reception signal processing unit 30 processes the light reception signals output from the plurality of pixels 100 disposed in the pixel array unit 10. The processing of the light reception signal processing unit 30 corresponds to, for example, the processing of detecting the distance to the object on the basis of the incident light detected by the pixel 100. Specifically, the light reception signal processing unit 30 can perform a time of flight (ToF) type of distance detection processing used when a distance to a distant object is measured in an imaging device such as an in-vehicle camera. This distance detection processing is processing to detect the distance by radiating the light from the light source disposed in the imaging device to the object to detect the light reflected by the object, and measuring the time the light from the light source takes to reciprocate between the light source and the object. The SPAD capable of high-speed photodetection is used as a device for performing such distance detection processing. The light reception signal processing unit 30 is an example of a processing circuit described in the claims.

A circuit configuration of the pixel 100 disposed in the pixel array unit 10 of the above-described embodiment will be described.

### [Configuration of Pixel]

Fig. 13 is a circuit diagram showing a configuration example of a pixel according to the distance measuring device to which the technology according to the present disclosure can be applied. The figure is a circuit diagram showing the configuration example of the pixel 100 described in Fig. 12. The pixel 100 in the figure includes a photoelectric conversion unit 101, a resistor 102, and an inverting buffer 103. Further, a signal line 21 in the figure is constituted by a signal line Vbd through which the breakdown voltage of the photoelectric conversion unit 101 is applied and a signal line Vd through which power for detecting a breakdown state of the photoelectric conversion unit 101 is supplied.

The anode of the photoelectric conversion unit 101 is connected to the signal line Vbd. A cathode of the photoelectric conversion unit 101 is connected to one end of the resistor 102 and an input of the inverting buffer 103. The other end of the resistor 102 is connected to the signal line Vd. An output of the inverting buffer 103 is connected to a signal line 31.

A reverse bias voltage is applied to the photoelectric conversion unit 101 in the figure through the signal line Vbd and the signal line Vd.

The resistor 102 is a resistor for performing quenching. This quenching is processing of returning the photoelectric conversion unit 101 in the breakdown state to that in a steady state. When the photoelectric conversion unit 101 is in the breakdown state due to the multiplying action caused by incidence of the light, a sudden reverse current flows through the photoelectric conversion unit 101. This reverse current increases a terminal voltage of the resistor 102. Since the resistor 102 is connected in series with the photoelectric conversion unit 101, a voltage drop occurs due to the resistor 102, and the terminal voltage of the photoelectric conversion unit 101 becomes lower than a voltage at which the breakdown state can be maintained. As a result, the photoelectric conversion unit 101 can be returned from the breakdown state to the steady state. Instead of the resistor 102, a constant current circuit with a MOS transistor can also be used.

The inverting buffer 103 is a buffer that shapes a pulse signal based on the transitioning and returning of the photoelectric conversion unit 101 to the breakdown state. The inverting buffer 103 generates a light reception signal based on the current flowing through the photoelectric conversion unit 101 according to the radiated light and outputs the generated signal to the signal line 31.

### [Configuration of Imaging Device]

Fig. 14 is a diagram showing a configuration example of an imaging device according to the distance measuring device to which the technology according to the present disclosure can be applied. The figure is a block diagram showing the configuration example of the imaging device 1 constituting the distance measuring device. The imaging device 1 in the figure includes a light receiving element 2, a control unit 3, a light source device 4, and a lens 5. In the figure, an object 601 for distance measurement is described.

The lens 5 is a lens that forms an image of the object on the light receiving element 2. The light receiving element 2 described in Fig. 8 can be used as the light receiving element 2.

The light source device 4 emits light to the object for distance measurement. For example, a laser light source that emits infrared light can be used as the light source device 4.

The control unit 3 controls the entire imaging device 1. Specifically, the control unit 3 controls the light source device 4 to emit emission light 602 to the object 601 and notifies the light receiving element 2 of the start of the emission. The light receiving element 2 notified of the emission of the emission light 602 detects reflected light 603 from the object 601, measures the time from the emission of the emission light 602 to the detection of the reflected light 603, and measures the distance to the object 601. This measured distance is output to the outside of the imaging device 1 as distance data. The imaging device 1 is an example of electronic equipment described in the claims.

### <8. Application Example to DVS>

The technology according to the present disclosure can be applied to various products. For example, the technology according to the present disclosure may be applied to a dynamic vision sensor (DVS). Here, the DVS is an imaging device that outputs information on a pixel whose brightness has changed.

### [Configuration of Light Receiving Element]

Fig. 15 is a diagram showing a configuration example of a light receiving element according to a DVS to which the technology according to the present disclosure can be applied. The light receiving element 2 in the figure includes a pixel array unit 10, a row drive circuit 50, a column drive circuit 60, and a signal processing circuit 70.

The pixel array unit 10 is configured by disposing a plurality of pixels 100 each having a photoelectric conversion unit that performs photoelectric conversion of the incident light in a two-dimensional grid shape. The pixel 100 detects the incident light and outputs a detection signal in a case where the detected incident light changes. Hereinafter, it is assumed that a photodiode is disposed in the pixel 100 as the photoelectric conversion unit. Signal lines 51, 61, and 71 are connected to each pixel 100. The signal line 51 is a signal line through which a row drive signal is transmitted. The signal line 51 is a signal line through which a column drive signal is transmitted. The signal line 71 is a signal line through which the detection signal from the pixel 100 is transmitted. In the pixel array unit 10 in the figure, an example in which the pixels 100 are disposed in 4 rows and 4 columns is described, but the number of pixels 100 disposed in the pixel array unit 10 is not limited to the example.

The row drive circuit 50 is a circuit that selects a row address of the pixel array unit 10 and causes the pixel 100 to output the detection signal corresponding to the selected row address. The row drive circuit 50 outputs a control signal (the row drive signal) to the signal line 51.

The column drive circuit 60 is a circuit that selects a column address of the pixel array unit 10 and causes the pixel 100 to output the detection signal corresponding to the selected column address. The column drive circuit 60 outputs a control signal (the column drive signal) to the signal line 61.

The signal processing circuit 70 executes predetermined signal processing on the detection signal from the pixel 100. The signal processing circuit 70 generates two-dimensional image data by associating the detection signal with the arrangement of the pixels 100 of the pixel array unit 10 and performs processing such as image recognition. The signal processing circuit 70 is an example of a processing circuit described in the claims.

### [Configuration of Pixel]

Fig. 16 is a diagram showing a configuration example of a pixel according to the DVS to which the technology according to the present disclosure can be applied. The pixel 100 in the figure includes a photoelectric conversion unit 201, a current-voltage conversion circuit 210, a buffer 220, a differentiator 230, a quantizer 240, and a transfer circuit 250.

The photoelectric conversion unit 201 detects the incident light. The photoelectric conversion unit 201 outputs a sink current corresponding to the incident light to the current-voltage conversion circuit 210 in a subsequent stage.

The current-voltage conversion circuit 210 is a circuit that converts an output current from the photoelectric conversion unit 201 into a voltage. During this conversion, logarithmic compression is performed and the compressed voltage signal is output to the buffer 220.

The buffer 220 is a buffer that amplifies the voltage signal of the current-voltage conversion circuit 210 and outputs the voltage signal to the differentiator 230 in a subsequent stage.

The differentiator 230 detects the amount of change in the voltage signal by detecting the difference in the voltage signal output from the buffer 220. The differentiator 230 starts detecting the amount of change in the voltage signal after the row drive signal is input from the row drive circuit 50. The amount of change in the detected voltage signal is output via a signal line 239.

The quantizer 240 quantizes the voltage signal from the differentiator 230 and outputs it as a detection signal. The detection signal is output via a signal line 249.

The transfer circuit 250 is a circuit that outputs the detection signal to the signal processing circuit 70 on the basis of the column drive signal from the column drive circuit 60.

### [Configuration of Current-voltage Conversion Circuit]

Fig. 17 is a diagram showing a configuration example of a current-voltage conversion circuit according to the DVS to which the technology according to the present disclosure can be applied. The figure is a circuit diagram showing the configuration example of the current-voltage conversion circuit 210. The current-voltage conversion circuit 210 in the figure includes MOS transistors 211 to 213 and a capacitor 214. An n-channel MOS transistor can be used for the MOS transistors 211 and 213. A p-channel MOS transistor can be used for the MOS transistors 212. Further, a power line Vdd and a power line Vbias are disposed in the current-voltage conversion circuit 210 of the figure. The power line Vdd is a power line through which power is supplied to the current-voltage conversion circuit 210. The power line Vbias is a power line through a bias voltage is supplied. In the figure, the photoelectric conversion unit 201 is also described.

An anode of the photoelectric conversion unit 201 is grounded, and a cathode thereof is connected to a source of the MOS transistor 211, a gate of the MOS transistor 213, and one end of the capacitor 214. The other end of the capacitor 214 is connected to a gate of the MOS transistor 211, a drain of the MOS transistor 212, a drain of the MOS transistor 213, and the signal line 219. The source of the MOS transistor 211 is connected to the power line Vdd, and a source of the MOS transistor 213 is grounded. A gate of the MOS transistor 212 is connected to the power line Vbias, and a source thereof is connected to the power line Vdd.

The MOS transistor 211 is a MOS transistor that supplies a current to the photoelectric conversion unit 201. The sink current corresponding to the incident light flows through the photoelectric conversion unit 201. The MOS transistor 211 supplies this sink current. At this time, the gate of the MOS transistor 211 is driven by an output voltage of the MOS transistor 213, which will be described later, and outputs a source current equal to the sink current of the photoelectric conversion unit 201. Since a gate-source voltage Vgs of the MOS transistor becomes a voltage corresponding to the source current, a source voltage of the MOS transistor becomes a voltage corresponding to the current of the photoelectric conversion unit 201. As a result, the current of the photoelectric conversion unit 201 is converted into a voltage signal.

The MOS transistor 213 is a MOS transistor that amplifies the source voltage of the MOS transistor 211. Further, the MOS transistor 212 constitutes a constant current load of the MOS transistor 213. The amplified voltage signal is output to the drain of the MOS transistor 213. This voltage signal is output to the signal line 219 and fed back to the gate of the MOS transistor 211. In a case where the Vgs of the MOS transistor 211 is equal to or less than a threshold voltage, the source current changes exponentially with respect to the change of the Vgs. Therefore, the output voltage of the MOS transistor 213 fed back to the gate of the MOS transistor 211 becomes a voltage signal in which the output current from the photoelectric conversion unit 201 equal to the source current of the MOS transistor 211 is logarithmically compressed.

The capacitor 214 is a capacitor for phase compensation. This capacitor 214 is connected between the drain and the gate of the MOS transistor 213 and performs phase compensation of the MOS transistor 213 constituting an amplifier circuit.

### [Configuration of Differentiator and Quantizer]

Fig. 18 is a view showing a configuration example of a differentiator and a quantizer according to the DVS to which the technology according to the present disclosure can be applied. The figure is a circuit diagram showing the configuration example of the differentiator 230 and the quantizer 240.

The differentiator 230 in the figure includes an inverting amplifier 231, capacitors 232 and 233, and a switch 234.

The capacitor 232 is connected between the signal line 229 and an input of the inverting amplifier 231. An output of the inverting amplifier 231 is connected to the signal line 239. The capacitor 233 and the switch 234 connected in parallel are connected between the input and the output of the inverting amplifier 231. A control input of the switch 234 is connected to the signal line 51.

The capacitor 232 is a coupling capacitor that removes a DC component of the voltage signal output from the buffer 220. A signal corresponding to the amount of change in the voltage signal is transmitted by the capacitor 232.

The inverting amplifier 231 is an amplifier that charges the capacitor 233 according to the amount of change in the voltage signal transmitted by the capacitor 232. The inverting amplifier 231 and the capacitor 232 constitute an integration circuit and integrate the amount of change in the voltage signal transmitted by the capacitor 232.

The switch 234 is a switch that discharges the capacitor 233. This switch 234 becomes conductive, discharges the capacitor 232, and resets the amount of change in the voltage signal integrated in the capacitor 232 to 0 V. The switch 234 is controlled with the row drive signal transmitted through the signal line 51.

The differentiator 230 integrates the amount of change in the voltage signal according to the incident light in a period after being reset with the row drive signal and outputs it. As a result, it is possible to reduce the influence of noise.

The quantizer 240 includes comparators 241 and 242. The signal line 239 is connected to a non-inverting input of the comparator 241 and an inverting input of the comparator 242. A predetermined threshold voltage Vth1 is applied to the inverting input of the comparator 241, and a predetermined threshold voltage Vth2 is applied to the non-inverting input of the comparator 242. The outputs of the comparators 241 and 242 each constitute a signal line 249.

The comparator 241 compares the threshold voltage Vth1 with the output voltage from the differentiator 230. In a case where the output voltage from the differentiator 230 is higher than the threshold voltage Vth1, a value "1" is output.

The comparator 242 compares the threshold voltage Vth2 with the output voltage from the differentiator 230. In a case where the output voltage from the differentiator 230 is lower than the threshold voltage Vth2, a value "1" is output.

By setting the threshold voltage Vth 1 to a threshold voltage higher than the output voltage when the differentiator 230 is reset and setting the threshold voltage Vth2 to a threshold voltage lower than the output voltage when the differentiator 230 is reset, it is possible to detect the amount of change in both the increase and decrease of the output signal from the photoelectric conversion unit 201. Further, the output voltage from the differentiator 230 is binarized to be quantized by the comparators 241 and 242.

The signal quantized by the quantizer 240 is input to the transfer circuit 250. When the signal of the value "1" is input, the transfer circuit 250 can transfer it to the signal processing circuit 70 as a detection signal indicating that the change in the incident light amount exceeds a predetermined threshold value. When the detection signal is transferred by the transfer circuit 250, the signal processing circuit 70 holds the transfer of the signal as an address event and causes the row drive unit 50 to output the row drive signal to the pixel 100 so as to reset the differentiator 230. As a result, in the pixel 100 in which the address event has occurred, the integration of the amount of change in the voltage signal according to the incident light is started again.

### [Configuration of Imaging Device]

Fig. 19 is a diagram showing a configuration example of an imaging device according to the DVS to which the technology according to the present disclosure can be applied. The figure is a block diagram showing the configuration example of the imaging device 1 constituting the DVS. The imaging device 1 in the figure includes a light receiving element 2, a control unit 3, a lens 5, and a recording unit 6.

The lens 5 is a lens that forms an image of the object on the light receiving element 2. The light receiving element 2 described in Fig. 11 can be used as the light receiving element 2.

The control unit 3 controls the light receiving element 2 to capture image data. The recording unit 6 records the image data by the light receiving element 2.

The light receiving element 2 can detect a region where the brightness has changed by acquiring the pixel 100 in which the address event is detected. By updating only the image data in the region and generating the image data, it is possible to perform high-speed imaging. The imaging device 1 is an example of electronic equipment described in the claims.

The separation region 150 of Figs. 5, 7, 8 and 10 may be applied to the pixel 100 of Fig. 11.

Finally, the descriptions of the above-described embodiments are merely examples of the present disclosure, and the present disclosure is not limited to the above-described embodiments. Therefore, it goes without saying that various changes aside from the above-described embodiments can be made according to the design and the like within a scope that does not depart from the technical spirit of the present disclosure.

Additionally, the effects described in the present specification are merely examples and are not limiting. Other effects may be obtained as well.

In addition, the drawings in the above-described embodiments are schematic, and dimensional ratios and the like of respective parts are not necessarily consistent with actual ones. In addition, it goes without saying that the drawings include parts where dimensional relationships and ratios differ from drawing to drawing.

The present technology can also have the following configurations.
(1) Alight receiving element including:
   pixels having photoelectric conversion units, each photoelectric conversion unit being disposed in a semiconductor substrate to perform photoelectric conversion of incident light;
   a wiring region having a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate; and
   a separation region that is disposed in the semiconductor substrate at a boundary between the pixels, is formed in a shape which penetrates the semiconductor substrate and in which a width on the front surface side is wider than a width on the back surface side, and separates the photoelectric conversion units from each other.
(2) The light receiving element according to (1), wherein the separation region is formed in a wall shape which surrounds the photoelectric conversion unit and is formed in a shape in which a width in a direction parallel to the surface of the semiconductor substrate is wider on the front surface side than on the back surface side.
(3) The light receiving element according to (1) or (2), wherein the separation region includes a wiring region adjacent portion that is disposed adjacent to the wiring region and is formed to have a width wider than the width on the front surface side.
(4) The light receiving element according to (3), wherein the separation region includes the wiring region adjacent portion formed to have a cross section of a reverse taper shape.
(5) The light receiving element according to (3), wherein the separation region includes the wiring region adjacent portion formed to have a cross section of a hemispherical shape.
(6) The light receiving element according to (3), wherein the separation region includes the wiring region adjacent portion formed from the front surface side of the semiconductor substrate.
(7) The light receiving element according to any one of (1) to (6), wherein the separation region is formed in a shape adjacent to the wiring layer.
(8) The light receiving element according to (7), further including:
   a wiring layer protective film disposed between the separation region and the wiring layer,
   wherein the separation region is adjacent to the wiring layer via the wiring layer protective film.
(9) The light receiving element according to any one of (1) to (8), wherein the separation region is formed to be disposed in a groove portion formed in the semiconductor substrate.
(10) The light receiving element according to (9), wherein the separation region is disposed in the groove portion having a shape in which the width on the front surface side of the semiconductor substrate is wider than the width on the back surface side thereof.
(11) The light receiving element according to (9), wherein the separation region is formed by disposing a metal in the groove portion.
(12) The light receiving element according to (11), wherein the separation region further includes an insulating film disposed between the semiconductor substrate and the separation region.
(13) The light receiving element according to (12), wherein the separation region includes the insulating film formed to have a shape in which a film thickness on the front surface side of the semiconductor substrate is thicker than a film thickness on the back surface side thereof.
(14) The light receiving element according to any one of (1) to (13), wherein the photoelectric conversion unit is constituted by a photodiode.
(15) The light receiving element according to (14), wherein the photoelectric conversion unit is constituted by the photodiode that multiplies charges generated through photoelectric conversion of the incident light with a high reverse bias voltage.
(16) The light receiving element according to (15), wherein, in the photoelectric conversion unit, the generated charges are multiplied in a pn junction constituted by a p-type semiconductor region and an n-type semiconductor region.
(17) The light receiving element according to (16), wherein the photoelectric conversion unit includes a cathode region constituted by the n-type semiconductor region.
(18) The light receiving element according to (17), wherein the photoelectric conversion unit includes the cathode region disposed on the front surface side of the semiconductor substrate.
(19) The light receiving element according to (15), wherein the separation region includes a wiring region adjacent portion which is adjacent to the wiring region and is formed to have a width wider than the width on the back surface side, the wiring region adjacent portion being disposed in a region closer to the wiring region than to a region in which the charges are multiplied in the photodiode.
(20) The light receiving element according to (19),
   wherein, in the photoelectric conversion unit, the generated charges are multiplied in a pn junction constituted by a p-type semiconductor region and an n-type semiconductor region, and
   wherein the separation region includes the wiring region adjacent portion formed to have a height lower than that of a region of the pn junction from the front surface side of the semiconductor substrate.
(21) The light receiving element according to any one of (15) to (20), wherein the photoelectric conversion unit includes an anode region disposed in the vicinity of the separation region on the front surface side of the semiconductor substrate.
(22) The light receiving element according to (21), wherein the wiring region includes the wiring layer which is disposed in the vicinity of the separation region and is connected to the anode region.
(23) Electronic equipment including:
   pixels having photoelectric conversion units, each photoelectric conversion unit being disposed in a semiconductor substrate to perform photoelectric conversion of incident light;
   a wiring region having a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate;
   a separation region that is disposed in the semiconductor substrate at a boundary between the pixels, is formed in a shape which penetrates the semiconductor substrate and in which a width on the front surface side is wider than a width on the back surface side, and separates the photoelectric conversion units from each other; and
   a processing circuit that performs processing for a signal generated on the basis of the photoelectric conversion.
(24) The electronic equipment according to (23),
   wherein the photoelectric conversion unit performs photoelectric conversion of the incident light that is incident on it, the incident light being obtained by light emitted from a light source being reflected by a subject, and
   wherein the processing circuit performs the processing for measuring a distance to the subject by measuring a time from radiation of the light from the light source to generation of the signal.
(25) The electronic equipment according to (23), wherein the processing circuit performs the processing for detecting an amount of change in the signal.
(26) The electronic equipment according to (25), wherein the processing circuit detects the amount of change by comparing with a predetermined threshold value.
(27) The electronic equipment according to any one of (23) to (26), wherein the processing circuit is disposed on a semiconductor substrate bonded to the semiconductor substrate.

### [Reference Signs List]

1 Imaging device
2 Light receiving element
10 Pixel array unit
30 Light reception signal processing unit
70 Signal processing circuit
100 Pixel
101, 201 Photoelectric conversion unit
110, 130 Semiconductor substrate
120, 140 Wiring region
121, 141 Insulating layer
122 to 124, 142 Wiring layer
150, 150a, 150b Separation region
151, 162 Groove portion
153, 163 Insulating film
154 Metal film
156 Wiring layer protective film
160, 161 Wiring region adjacent portion

## Claims

1. A light receiving element comprising:
pixels having photoelectric conversion units, each photoelectric conversion unit being disposed in a semiconductor substrate to perform photoelectric conversion of incident light;
a wiring region having a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate; and
a separation region that is disposed in the semiconductor substrate at a boundary between the pixels, is formed in a shape which penetrates the semiconductor substrate and in which a width on the front surface side is wider than a width on the back surface side, and separates the photoelectric conversion units from each other.

2. The light receiving element according to claim 1, wherein the separation region is formed in a wall shape which surrounds the photoelectric conversion unit and is formed in a shape in which a width in a direction parallel to the surface of the semiconductor substrate is wider on the front surface side than on the back surface side.

3. The light receiving element according to claim 1, wherein the separation region includes a wiring region adjacent portion that is disposed adjacent to the wiring region and is formed to have a width wider than the width on the front surface side.

4. The light receiving element according to claim 3, wherein the separation region includes the wiring region adjacent portion formed to have a cross section of a reverse taper shape.

5. The light receiving element according to claim 3, wherein the separation region includes the wiring region adjacent portion formed to have a cross section of a hemispherical shape.

6. The light receiving element according to claim 3, wherein the separation region includes the wiring region adjacent portion formed from the front surface side of the semiconductor substrate.

7. The light receiving element according to claim 1, wherein the separation region is formed in a shape adjacent to the wiring layer.

8. The light receiving element according to claim 7, further comprising:
a wiring layer protective film disposed between the separation region and the wiring layer,
wherein the separation region is adjacent to the wiring layer via the wiring layer protective film.

9. The light receiving element according to claim 1, wherein the separation region is formed to be disposed in a groove portion formed in the semiconductor substrate.

10. The light receiving element according to claim 9, wherein the separation region is disposed in the groove portion having a shape in which the width on the front surface side of the semiconductor substrate is wider than the width on the back surface side thereof.

11. The light receiving element according to claim 9, wherein the separation region is formed by disposing a metal film in the groove portion.

12. The light receiving element according to claim 11, wherein the separation region further includes an insulating film disposed between the semiconductor substrate and the metal film.

13. The light receiving element according to claim 12, wherein the separation region includes the insulating film formed to have a shape in which a film thickness on the front surface side of the semiconductor substrate is thicker than a film thickness on the back surface side thereof.

14. The light receiving element according to claim 1, wherein the photoelectric conversion unit is constituted by a photodiode.

15. The light receiving element according to claim 14, wherein the photoelectric conversion unit is constituted by the photodiode that multiplies charges generated through photoelectric conversion of the incident light with a high reverse bias voltage.

16. The light receiving element according to claim 15, wherein, in the photoelectric conversion unit, the generated charges are multiplied in a pn junction constituted by a p-type semiconductor region and an n-type semiconductor region.

17. The light receiving element according to claim 16, wherein the photoelectric conversion unit includes a cathode region constituted by the n-type semiconductor region.

18. The light receiving element according to claim 17, wherein the photoelectric conversion unit includes the cathode region disposed on the front surface side of the semiconductor substrate.

19. The light receiving element according to claim 15, wherein the separation region includes a wiring region adjacent portion which is adjacent to the wiring region and is formed to have a width wider than the width on the back surface side, the wiring region adjacent portion being disposed in a region closer to the wiring region than to a region in which the charges are multiplied in the photodiode.

20. The light receiving element according to claim 19,
wherein, in the photoelectric conversion unit, the generated charges are multiplied in a pn junction constituted by a p-type semiconductor region and an n-type semiconductor region, and
wherein the separation region includes the wiring region adjacent portion formed to have a height lower than that of a region of the pn junction from the front surface side of the semiconductor substrate.

21. The light receiving element according to claim 15, wherein the photoelectric conversion unit includes an anode region disposed in the vicinity of the separation region on the front surface side of the semiconductor substrate.

22. The light receiving element according to claim 21, wherein the wiring region includes the wiring layer which is disposed in the vicinity of the separation region and is connected to the anode region.

23. Electronic equipment comprising:
pixels having photoelectric conversion units, each photoelectric conversion unit being disposed in a semiconductor substrate to perform photoelectric conversion of incident light;
a wiring region having a wiring layer that is connected to the photoelectric conversion unit to transmit a signal and an insulating layer that insulates the wiring layer, the wiring region being disposed adjacent to a front surface which is a surface opposite to a back surface which is a surface on which the incident light is incident in the semiconductor substrate;
a separation region that is disposed in the semiconductor substrate at a boundary between the pixels, is formed in a shape which penetrates the semiconductor substrate and in which a width on the front surface side is wider than a width on the back surface side, and separates the photoelectric conversion units from each other; and
a processing circuit that performs processing for a signal generated on the basis of the photoelectric conversion.

24. The electronic equipment according to claim 23,
wherein the photoelectric conversion unit performs photoelectric conversion of the incident light that is incident on it, the incident light being obtained by light emitted from a light source being reflected by a subject, and
wherein the processing circuit performs the processing for measuring a distance to the subject by measuring a time from radiation of the light from the light source to generation of the signal.

25. The electronic equipment according to claim 23, wherein the processing circuit performs the processing for detecting an amount of change in the signal.

26. The electronic equipment according to claim 25, wherein the processing circuit detects the amount of change by comparing with a predetermined threshold value.

27. The electronic equipment according to claim 23, wherein the processing circuit is disposed on a semiconductor substrate bonded to the semiconductor substrate.
